# EUROPEAN PATENT SPECIFICATION

(11) **EP 0 629 110 B1**
(45) Date of publication and mention of the grant of the patent: **23.01.2002**
(21) Application number: 94108706.6
(22) Date of filing: 07.06.1994
(51) Int. Cl.: H05K 3/20

(54) **Method of forming conductive pattern on substrate**
Verfahren zur Bildung eines leitfähigen Musters auf einem Substrat
Procédé de formation d'un motif conducteur sur un substrat

(30) Priority: 10.06.1993 JP 13860393
(43) Date of publication of application: 14.12.1994
(73) Proprietor: MURATA MANUFACTURING CO., LTD., Nagaokakyo-shi Kyoto-fu 226 (JP)
(72) Inventor: Kohno, Yoshiaki, Nagaokakyo-shi, Kyoto-fu (JP); Suzuki, Tatsuya, Nagaokakyo-shi, Kyoto-fu (JP)
(74) Representative: TER MEER STEINMEISTER & PARTNER GbR

(56) References cited:
- EP-A- 0 381 879
- EP-A- 0 485 176
- PATENT ABSTRACTS OF JAPAN vol. 16 no. 381 (E-1248) ,14 August 1992 & JP-A-04 122093 (FUJITSU) 22 April 1992,

## Description

### Field of the Invention

The present invention relates generally to a method of forming a conductive pattern on a substrate or on an insulating layer in a multilayer substrate, and more particularly, to a method in which a complicated conductive pattern can be formed easily and at low cost.

### Description of the Prior Art

With the miniaturization of an electronic equipment and an electronic component, a wiring pattern on a substrate or in a multilayer substrate has been complicated and increased in density. As a method of forming the above described wiring pattern, the following methods have been conventionally employed:

(1) a method of printing a conductive paste on a substrate or on an insulating layer to form a wiring pattern, (2) a method of forming a metal thin film throughout on a substrate or on an insulating layer by a thin film forming process and then, finely processing the metal thin film by a photolithographic technique to form a wiring pattern having a desired shape, (3) a method of disposing a mask on a substrate or on an insulating layer and then forming a wiring pattern by a thin film forming process, and (4) a method of disposing a mask on a supporting member composed of a synthetic resin film or the like, forming a metal thin film having a desired pattern and then transferring the metal thin film from the supporting member to a substrate or on an insulating layer.

An ordinary circuit board is constructed by forming the wiring pattern on a substrate using the foregoing various methods. On the other hand, a multilayer substrate is constructed by forming a desired wiring pattern on an insulating layer using the foregoing various methods and then, laminating insulating layers each having the wiring pattern formed thereon.

In a wiring pattern obtained by printing a conductive paste and sintering the same using the method (1), the density of a metal is low, so that sufficient current-carrying capacity cannot be obtained. When an attempt to ensure some current-carrying capacity is made, therefore, the wiring pattern cannot be thinned or narrowed. Accordingly, the method (1) is not suited to form a complicated and high-density wiring pattern.

In the respective methods (2) to (4), a wiring pattern is formed of a metal thin film, so that sufficient current-carrying capacity can be ensured. Therefore, the wiring pattern can be thinned and narrowed, thereby to make it possible to form a high-density wiring pattern. If the shape of the wiring pattern becomes complicated, however, it is difficult to increase the density of the wiring pattern. Particularly when a change of the wiring pattern is required, for example, masks such as a mask used for photolithography and a mask used by a thin film forming process must be produced again, resulting in significantly high cost. Moreover, when the thickness of the wiring pattern is decreased, it is difficult to form a wiring pattern in a desired position or transfer the same as the density of the wiring pattern is increased, and a wiring portion is liable to be cut off, for example, in the case of the transfer.

The above described problems similarly occur even when not only a mere wiring pattern but also a conductive pattern including, for example, a functional conductor portion such as a conductor portion for constituting an inductor in its part must be formed.

EP-A-0 381 879 discloses a method of manufacturing laminated ceramic electronic components, in which a metal film is formed on a carrier film and in which a part of the metal film is transferred onto a ceramic green sheet.

### SUMMARY OF THE INVENTION

An object of the present invention is to provide a method of forming a conductive pattern on a substrate or on an insulating layer disposed in a substrate, in which a complicated and high-density conductive pattern can be formed easily and at low cost.

According to the present invention, there is provided a method of forming a predetermined conductive pattern on a substrate or on an insulating layer disposed in a substrate, which comprises the steps of preparing a plurality of transferring metal band supplying members each having at least one metal band formed by a thin film forming process formed on a supporting member, the shape of each of the plurality of metal bands formed in the plurality of transferring metal band supplying members being formed so that, when collected at a later stage, the metal bands form the predetermined conductive pattern, and sequentially transferring the plurality of metal bands on the substrate or on the insulating layer disposed in the substrate using the plurality of transferring metal band supplying members to form the predetermined conductive pattern.

In the present invention, a predetermined conductive pattern is formed on a substrate or on an insulating layer disposed in a substrate by a transfer process as described above. In the present invention, a plurality of transferring metal band supplying members used for the transfer are prepared, and at least one metal band is formed in each of the plurality of transferring metal band supplying members. In addition, the shape of each of the plurality of metal bands formed in the plurality of transferring metal band supplying members is selected so that the metal bands are collected to form a desired conductive pattern. Consequently, the metal bands are sequentially transferred from the plurality of transferring metal band supplying members, thereby to form the desired conductive pattern on the substrate or on the insulating layer disposed in the substrate. Thus, since a square of a part transferred at once is small, the pressure on the transferring can be uniform and thus the metal band can be uniformly removed. Further, it becomes possible to prevent air from entering between the metal band and the substrate. Even if the conductive pattern is complicated in wiring shape and is high in density, therefore, the conductive pattern can be transferred easily and stably because it is partially transferred. Accordingly, the metal band is not easily cut off, for example. Further, even when the metal band is further thinned or narrowed, it is possible to stably form the desired conductive pattern.

Additionally, the above described conductive pattern is constituted by the metal bands formed by the thin film forming process, so that sufficient current-carrying capacity can be ensured. Accordingly, the conductive pattern itself can be thinned and narrowed.

Moreover, the conductive pattern is divisionally transferred as described above. In changing the conductive pattern, therefore, transferring metal band supplying members having metal bands changed in shape in only a portion where the conductive pattern is changed may be prepared, thereby to make it possible to form a conductive pattern having a complicated shape at low cost.

In accordance with a particular aspect of the present invention, the conductive pattern constituted by the plurality of metal bands is a wiring pattern, thereby to make it possible to provide a circuit board or a multilayer substrate having a predetermined wiring pattern formed thereon.

Furthermore, a functional element film such as a resistance film may be formed in the middle of at least one of the metal bands, thereby to make it possible to form a functional element such as a resistance element in the middle of the metal band.

Additionally, the above described metal bands may be patterned in a collected state so as to form a coil pattern in at least a part of the conductive pattern, so that the coil pattern can constitute an inductor.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a plan view for explaining a conductive pattern obtained by an embodiment;
Fig. 2 is a schematic plan view for explaining regions obtained by division on a substrate;
Figs. 3A to 3C are plan views respectively showing transferring metal band supplying members;
Figs. 4A to 4B are cross sectional views for respectively explaining the process of laminating ceramic-glass raw sheets in the embodiment; and
Figs. 5A to 5B are cross sectional view for respectively explaining the process of laminating ceramic-glass raw sheets in the embodiment.

### DESCRIPTION OF THE PREFERRED EMBODIMENTS

Embodiments will be described while referring to the drawings, to clarify the present invention.

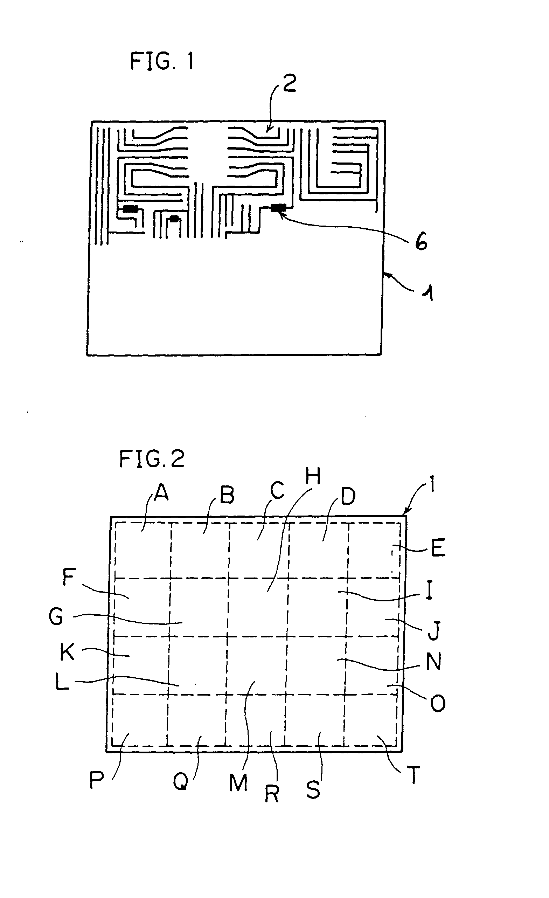

Fig. 1 is a plan view for explaining a wiring pattern finally formed according to the present embodiment.

Referring to Fig. 1, a conductive pattern 2 is formed on an insulating substrate 1.

In the present embodiment, the conductive pattern 2 is formed by transferring metal bands from a plurality of transferring metal band supplying members as described later.

Fig. 2 is a schematic plan view showing a state where the above described substrate 1 is divided into 5 rows x 4 columns = 20 regions. In the present embodiment, the metal bands are transferred in each of the 20 regions A to T, to sequentially transfer parts of the conductive pattern 2 shown in Fig. 1.

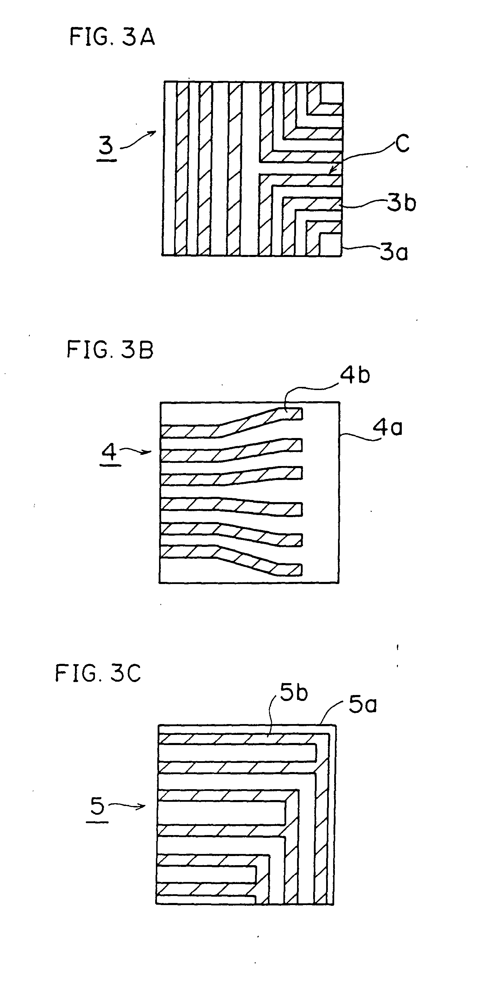

Figs. 3A to 3C are plan views respectively showing the transferring metal band supplying members used in the present embodiment.

The transferring metal band supplying member 3 has a structure in which metal bands 3b mainly composed of Ag and formed by a thin film forming process are formed on a supporting member 3a composed of a synthetic resin film such as a polyethylene terephtalate film or a polypropylene film. Examples of the thin film forming process include vacuum evaporation, sputtering, electroplating, electroless plating and ion plating. The metal bands 3b correspond to metal bands transferred in the region A in Fig. 2.

A metal band supplying member 4 has a structure in which metal bands 4b mainly composed of Ag are formed by the thin film forming process on a supporting member 4a constructed similarly to the supporting member 3a. The metal bands 4b are in a shape transferred in the region B in Fig. 2.

Furthermore, a transferring metal band supplying member 5 has a structure in which metal bands 5b mainly composed of Ag are formed by the thin film forming process on a supporting member 5a similarly constructed. The metal bands 5b are in such a plane shape as to form a conductive pattern in a portion corresponding to the region E in Fig. 2.

Although only the above described three types of transferring metal band supplying members are shown in Fig. 3, transferring metal band supplying members for transferring metal bands are respectively prepared in the remaining regions shown in Fig. 2 in the same manner.

Although in the transferring metal band supplying members 3 to 5 shown in Fig. 3A to 3C, the metal bands 3b, 4b and 5b are so respectively constructed as to form a mere wiring pattern, some of the remaining transferring metal band supplying members have a structure in which a resistance film is connected to the middle of a metal band so as to construct a resistor. For example, a resistance element is connected as shown to a portion indicated by reference numeral 6 in Fig. 1. The resistance film is transferred simultaneously with the transfer of the metal band by connecting the resistance film to a middle portion of the metal band as described above, to form such a resistance element.

In a method of forming a conductive pattern on a substrate according to the present embodiment, functional element film portions such as metal bands and resistance films are transferred from the transferring metal band supplying members in the respective regions A to T shown in Fig. 2 as described above, thereby to finally form the conductive pattern 2 shown in Fig. 1.

Therefore, the conductive pattern 2 shown in Fig. 2 must be divided into a plurality of metal bands so as to be formed in a state where the metal bands formed on the plurality of transferring metal band supplying members are collected.

A part of each of the metal bands 3b to 5b formed on the respective transferring metal band supplying members 3 to 5 may be provided with a coil-shaped pattern, as indicated by, for example, an arrow C in Fig. 3A, so that the coil-shaped pattern can function as an inductor. Such a functional conductive pattern portion shall be included in an expression "conductive pattern" in the present invention.

Description is now made of the specific results of experiments conducted on the above described embodiment.

First, powder of alumina Al₂O₃ and powder of borosilicate glass are respectively weighed so that the weight ratio is 55 : 45, are dispersed along with an organic binder in a solvent and are thoroughly mixed, thereby to obtain a slurry. The slurry obtained is used, thereby to produce a ceramic - glass raw sheet having a uniform thickness (10 µm) on a synthetic resin film. The ceramic-glass raw sheet is irradiated by laser light, thereby to form a through hole in a predetermined portion of the ceramic - glass raw sheet. The through hole is filled with a silver paste obtained by thoroughly mixing the powder of silver and that of glass, to form a through hole electrode.

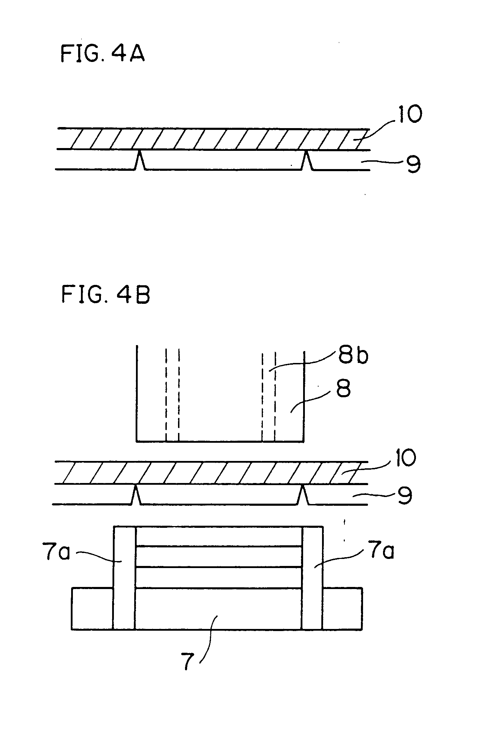

In the above described manner, the ceramic - glass raw sheet having the through hole electrode formed therein is previously notched to predetermined lengths, as shown in Fig. 4A. The ceramic - glass raw sheet is located between a base plate 7 provided with a frame 7a and a punch 8, as shown in Fig. 4B. The frame 7a is moved up and down relative to the base plate 7, and is positioned at a height equal to or less than the height of the uppermost surface of raw sheets already laminated in the case of pressing, as described later. In addition, the punch 8 is also moved up and down and has a suction hole 8b for fixing the ceramic-glass raw sheet. The suction hole 8b is connected to a suction source such as a vacuum pump (not shown).

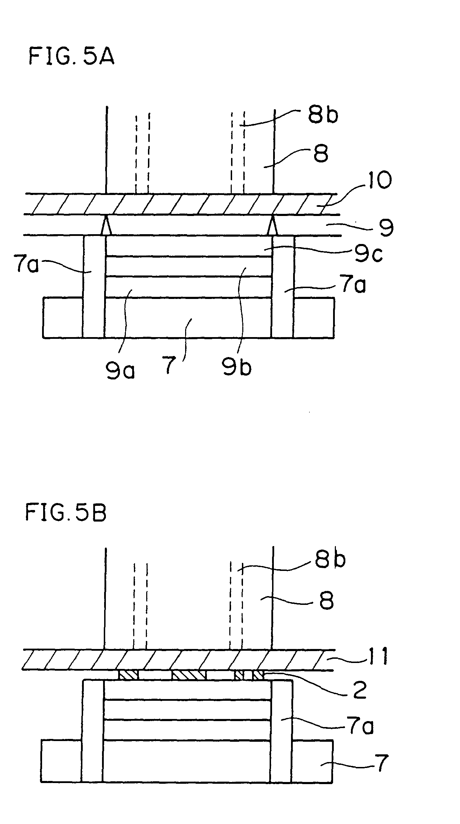

A ceramic - glass raw sheet 9 prepared in the above described manner is pressed on raw sheets 9a to 9c already laminated inside of the base plate 7 by applying pressure using the punch 8 in a state where it is supported by a synthetic resin film 10, as shown in Fig. 5A. Thereafter, the synthetic resin film 10 fixed to the punch 8 by suction from the suction hole 8b is stripped from a cut portion of the ceramic - glass raw sheet 9 by raising the punch 8, thereby to obtain a raw substrate in which the ceramic-glass raw sheets 9 and 9a to 9c are affixed to each other.

The metal bands are then sequentially transferred to the regions A to T shown in Fig. 2, using the plurality of transferring metal band supplying members 11 including the transferring metal band supplying members shown in Figs. 3A to 3C between the punch 8 and the base plate 7, as shown in Fig. 5B, thereby to form the conductive pattern 2 shown in Fig. 1 which is constituted by the metal bands.

After the conductive pattern 2 corresponding to one layer is formed in the above described manner, a new ceramic - glass raw sheet is located between the punch 8 and the base plate 7. The new ceramic - glass raw sheet is pressed on a portion where the conductive pattern 2 is formed by repeating the foregoing process, and a conductive pattern is similarly formed again by a transfer process.

The foregoing process is repeated a predetermined number of times, thereby to obtain a laminated raw substrate having a plurality of predetermined conductive pattern layers laminated in the frame 7a. After the laminated raw substrate obtained is taken out of a laminated raw stage, is produced in a rectangular plane shape 50 mm square, and is sintered at a temperature of 900°, a predetermined outer electrode to be connected to an inner conductive pattern is formed by plating on a sintered multilayer substrate obtained, thereby to obtain a ceramic multilayer substrate.

Although in the above described embodiment, the method according to the present invention is used so as to form the conductive pattern in the ceramic multilayer substrate, the present invention is also applicable to a case where a conductive pattern is formed on a single plate type circuit board.

Although the present invention has been described and illustrated in detail, it is clearly understood that the same is by way of illustration and example only and is not to be taken by way of limitation, the scope of the present invention being limited only by the terms of the appended claims.

## Claims

1. A method of forming a predetermined conductive pattern (2) on a substrate (1) or on an insulating layer disposed in a substrate (1), comprising the steps of:
preparing a plurality of transferring metal band supplying members (3, 4, 5) each having at least one metal band (3b, 4b, 5b) formed by a thin film forming process formed on a supporting member (3a, 4a, 5a), the shape of each of the plurality of metal bands (3b, 4b, 5b) formed in the plurality of transferring metal band supplying members (3, 4, 5) being formed so that, when collected at a later stage, the metal bands form said predetermined conductive pattern (2); and consequently
transferring sequentially said plurality of metal bands (3b, 4b, 5b) on said substrate (1) or on said insulating layer disposed in the substrate (1) using said plurality of transferring metal band supplying members (3, 4, 5) to form said predetermined conductive pattern (2).

2. The method according to claim 1, wherein said thin film forming process is at least one of vacuum evaporation, sputtering, ion plating, electroplating, and electroless plating.

3. The method according to claim 1, wherein said conductive pattern constituted by said plurality of metal bands (3b, 4b, 5b) is a wiring pattern.

4. The method according to claim 1, wherein a functional element film (6) is formed in the middle of at least one of said metal bands so as to be connected to the metal band.

5. The method according to claim 4, wherein said functional element film is a resistance film (6).

6. The method according to claim 1, wherein a coil pattern (C) is formed in at least a part of the conductive pattern formed by collecting said plurality of metal bands.

7. The method according to claim 1, wherein the insulating layer disposed in said substrate (1) is a green sheet containing ceramics, further comprising the step of
forming a conductive pattern on the green sheet and then, laminating another green sheet, and sintering a laminated body obtained to obtain a ceramic multilayer substrate.

## Patentansprüche

1. Verfahren zum Herstellen eines vorbestimmten leitenden Musters (2) auf einem Substrat (1) oder einer in einem Substrat (1) angeordneten Isolierschicht, mit den folgenden Schritten:
- Herstellen mehrerer übertragender Metallband-Zuführelement (3, 4, 5), von denen jedes mindestens ein durch einen Dünnfilm-Herstellprozess auf einem Trägerelement (3a, 4a, 5a) hergestelltes Metallband (3b, 4b, 5b) aufweist, wobei die Form der mehreren in den mehreren übertragenden MetallbandZuführelementen (3, 4, 5) hergestellten Metallbänder (3b, 4b, 5b) dergestalt ist, dass die Metallbänder dann, wenn sie in einer späteren Stufe zusammengestellt sind, das vorbestimmte leitende Muster (2) bilden; und anschließend
- sequenzielles Übertragen der mehreren Metallbänder (3b, 4b, 5b) auf das Substrat (1) oder die im Substrat (1) angeordnete Isolierschicht unter Verwendung der mehreren übertragenden Metallband-Zuführelement (3, 4, 5), um das genannte vorbestimmte leitende Muster (2) herzustellen.

2. Verfahren nach Anspruch 1, bei dem der Dünnfilm-Herstellprozess mindestens einer der folgenden Prozesse ist: Aufdampfen im Vakuum, Sputtern, Ionenplattieren, Elektroplattieren und stromloses Plattieren.

3. Verfahren nach Anspruch 1, bei dem das aus den mehreren Metallbändern (3b, 4b, 5b) gebildete leitende Muster ein Leiterbahnmuster ist.

4. Verfahren nach Anspruch 1, bei dem im Verlauf mindestens eines der Metallbänder ein Funktionselement-Film (6) so hergestellt wird, dass er mit dem Metallband verbunden ist.

5. Verfahren nach Anspruch 4, bei dem der Funktionselement-Film ein Widerstandsfilm (6) ist.

6. Verfahren nach Anspruch 1, bei dem mindestens in einem Teil des durch Sammeln der mehreren Metallbänder erzeugten leitenden Musters ein Spulenmuster (C) hergestellt wird.

7. Verfahren nach Anspruch 1, bei dem die im Substrat (1) angeordnete Isolierschicht eine eine Keramik enthaltende Grünlage ist, ferner mit dem folgenden Schritt:
- Herstellen eines leitenden Musters auf der Grünlage und anschließendes Auflaminieren einer anderen Grünlage, sowie Sintern eines erhaltenen Laminatkörpers, um ein keramisches Mehrschichtsubstrat zu erhalten.

## Revendications

1. Procédé de formation d'un motif conducteur prédéterminé (2) sur un substrat (1) ou sur une couche isolante disposée dans un substrat (1), comprenant les étapes suivantes :
la préparation de plusieurs organes (3, 4, 5) de transmission de bandes métalliques de transfert ayant chacun au moins une bande métallique (3b, 4b, 5b) formée par un procédé de formation en couches minces sur un organe de support (3a, 4a, 5a), la configuration de chacune des bandes métalliques (3b, 4b, 5b) formées dans les organes (3, 4, 5) de transmission de bandes métalliques de transfert étant réalisée afin que, après collecte à un stade postérieur, les bandes métalliques forment le motif conducteur prédéterminé (2), puis
le transfert séquentiel des bandes métalliques (3b, 4b, 5b) sur le substrat (1) ou sur la couche isolante disposée dans le substrat (1) à l'aide des organes (3, 4, 5) de transmission de bandes métalliques de transfert pour la formation du motif conducteur prédéterminé (2).

2. Procédé selon la revendication 1, dans lequel l'opération de formation de couches minces est au moins une opération d'évaporation sous vide, de pulvérisation, de dépôt ionique, d'électrodéposition ou de dépôt chimique.

3. Procédé selon la revendication 1, dans lequel le motif conducteur constitué par les bandes métalliques (3b, 4b, 5b) est un motif de câblage.

4. Procédé selon la revendication 1, dans lequel une couche (6) d'un élément fonctionnel est formée au milieu de l'une au moins des bandes métalliques afin qu'elle soit connectée à la bande métallique.

5. Procédé selon la revendication 4, dans lequel la couche d'élément fonctionnel est une couche de résistance (6).

6. Procédé selon la revendication 1, dans lequel un motif d'enroulement (C) est formé dans une partie au moins du motif conducteur formé par collecte des bandes métalliques.

7. Procédé selon la revendication 1, dans lequel la couche isolante disposée dans le substrat (1) est une feuille crue contenant une céramique, le procédé comprenant en outre l'étape suivante :
la formation d'un motif conducteur sur la feuille crue, puis l'empilement d'une autre feuille crue, et le frittage d'un corps stratifié obtenu pour l'obtention d'un substrat céramique multicouche.
